# EUROPEAN PATENT APPLICATION

(11) **EP 4 641 666 A1**
(43) Date of publication of application: **29.10.2025**
(21) Application number: 23907518.7
(22) Date of filing: 06.12.2023
(51) Int. Cl.: H01M 4/36, H01M 4/525, H01M 4/505, H01M 10/052, H01M 4/02

(54) **POSITIVE ACTIVE MATERIAL FOR RECHARGEABLE LITHIUM BATTERY, AND RECHARGEABLE LITHIUM BATTERY INCLUDING SAME**

(30) Priority: 23.12.2022 KR 20220183304
(71) Applicant: Posco Future M Co., Ltd., Pohang-si, Gyeongsangbuk-do 37918 (KR)
(72) Inventor: CHOI, Kwonyoung, Pohang-si, Gyeongsangbuk-do 37918 (KR); KIM, Seong In, Pohang-si, Gyeongsangbuk-do 37918 (KR); LIM, Seokjae, Pohang-si, Gyeongsangbuk-do 37918 (KR); PARK, Jeonghyeon, Pohang-si, Gyeongsangbuk-do 37918 (KR); LEE, Ui Tae, Pohang-si, Gyeongsangbuk-do 37918 (KR); LEE, Su Jin, Pohang-si, Gyeongsangbuk-do 37918 (KR); HAN, Seul Ki, Pohang-si, Gyeongsangbuk-do 37918 (KR); JEONG, Il Rok, Pohang-si, Gyeongsangbuk-do 37918 (KR); KIM, Jeong Han, Pohang-si, Gyeongsangbuk-do 37918 (KR); CHANG, Joon Ha, Pohang-si, Gyeongsangbuk-do 37918 (KR)
(74) Representative: Meissner Bolte Partnerschaft mbB
(86) International application number: PCT/KR2023/020023
(87) International publication number: WO 2024/136232

(57) **Abstract**

The present exemplary embodiments relate to a positive electrode active material for a lithium secondary battery, and a lithium secondary battery including the same. The positive electrode active material for a lithium secondary battery according to an exemplary embodiment includes: a metal oxide in the form of a single particle; and a coating layer positioned on the surface of the metal oxide, wherein a concentration of lithium in a 2/5 to 3/5 thickness area based on the total thickness of the coating layer has a lower value than a concentration of lithium in the metal oxide.

## Description

### [Technical Field]

The present exemplary embodiments relate to a positive electrode active material for a lithium secondary battery and a lithium secondary battery including the same.

### [Background Art]

In recent years, due to an explosive demand for electric vehicles and a demand for increased driving distance, development of a secondary battery having a high capacity and a high energy density for meeting the demands is actively progressing worldwide.

As a way to meet the demands, a technology of using a high nickel-based nickel cobalt manganese (NCM) positive electrode material having a high Ni content has been suggested. In addition, in order to improve a plate density of an electrode which is a cell constituent element, it should be composed of a bimodal form in which large particles and small particles are blended in a certain fraction.

However, since a positive electrode material form composed of a secondary particle form formed by agglomeration of primary particles having a size from tens of nm to several µm has a large powder specific surface area, it has a large area in contact with an electrolytic solution, which causes a high possibility of gassing and deterioration of life characteristics.

In order to solve the problem, a method of increasing the size of primary particles using a sintering agent, a flux, or the like has been suggested. However, in this case, a rocksalt structure is produced on the surface portion of the particles to deteriorate the electrochemical performance of the positive electrode active material.

Accordingly, development of a positive electrode active material which has excellent electrochemical performance while increasing the size of the primary particles is required.

### [Disclosure]

### [Technical Problem]

The present disclosure attempts to provide a positive electrode active material capable of having a single particle form and having excellent electrochemical performance, and a lithium secondary battery including the same.

### [Technical Solution]

In one general aspect, a positive electrode active material for a lithium secondary battery includes: a metal oxide in the form of a single particle; and a coating layer positioned on the surface of the metal oxide, wherein a concentration of lithium in a 2/5 to 3/5 thickness area based on the total thickness of the coating layer has a lower value than a concentration of lithium in the metal oxide.

In another general aspect, a lithium secondary battery includes the positive electrode; a negative electrode; and an electrolyte.

### [Advantageous Effects]

The positive electrode active material for a lithium secondary battery according to an exemplary embodiment may dramatically improve the electrochemical performance of a lithium secondary battery to which a positive electrode active material in the form of a single particle is applied, by modifying the surface by a method of forming a coating layer on the surface of a metal oxide and controlling a concentration of lithium in a certain thickness area based on a half point of a coating layer thickness.

### [Description of the Drawings]

FIG. 1 is an SEM image measured at 20,000X magnification for a positive electrode active material prepared according to Example 2.
FIG. 2 is an SEM image measured at 20,000X magnification for a positive electrode active material prepared according to Example 4.
FIG. 3 is an SEM image measured at 20,000X magnification for a positive electrode active material prepared according to Comparative Example 2.
FIG. 4 is a cross-sectional TEM image of the positive electrode active material prepared according to Example 4 after a milling treatment with Focused Ion Beam (FIB, SEIKO 3050SE).
FIGS. 5 to 7 show results after element mapping of the positive electrode active material prepared according to Example 4 using Energy dispersed spectroscopy (EDS, Oxford X_max 100TLE) analysis equipment, respectively.
FIG. 8 is a TEM-EDS line scanning graph of FIG. 4.
FIG. 9 is an EELS graph at point 1, point 2, and point 3 of FIG. 4.
FIG. 10 is a cross-sectional TEM image of positive electrode active material prepared according to Comparative Example 2 after a milling treatment with Focused Ion Beam (FIB, SEIKO 3050SE).
FIGS. 11 to 13 show results after element mapping of the positive electrode active material prepared according to Comparative Example 2 using Energy dispersed spectroscopy (EDS, Oxford X_max 100TLE) analysis equipment, respectively.
FIG. 14 is a TEM-EDS Line scanning graph of FIG. 10.
FIG. 15 is an EELS graph at point 1, point 2, and point 3 of FIG. 10.
FIG. 16 is an SEM image measured at 5,000X magnification for a positive electrode active material prepared according to Example 8.

### [Mode for Invention]

The terms such as first, second, and third are used for describing various parts, components, areas, layers, and/or sections, but are not limited thereto. These terms are used only for distinguishing one part, component, area, layer, or section from other parts, components, areas, layers, or sections. Therefore, a first part, component, area, layer, or section described below may be mentioned as a second part, component, area, layer, or section without departing from the scope of the present disclosure.

The terminology used herein is only for mentioning a certain example, and is not intended to limit the present disclosure. Singular forms used herein also include plural forms unless otherwise stated clearly to the contrary. The meaning of "comprising" used in the specification is embodying certain characteristics, areas, integers, steps, operations, elements, and/or components, but is not excluding the presence or addition of other characteristics, areas, integers, steps, operations, elements, and/or components.

When it is mentioned that a part is "on" or "above" the other part, it means that the part is directly on or above the other part or another part may be interposed therebetween. In contrast, when it is mentioned that a part is "directly on" the other part, it means that nothing is interposed therebetween.

Though not defined otherwise, all terms including technical terms and scientific terms used herein have the same meaning as commonly understood by a person with ordinary skill in the art to which the present disclosure pertains. Terms defined in commonly used dictionaries are further interpreted as having a meaning consistent with the related technical literatures and the currently disclosed description, and unless otherwise defined, they are not interpreted as having an ideal or very formal meaning.

### Positive electrode active material for lithium secondary battery

As described above, when the size of primary particles is increased, a rocksalt structure is produced on the surface to deteriorate electrochemical performance of a positive electrode active material. However, in the present exemplary embodiment, the problem has been solved by implementing a positive electrode active material having a surface structure modified by a method of controlling a concentration of lithium in a certain thickness area based on a half point of a coating layer thickness in a coating layer positioned on the surface of a metal oxide.

That is, the positive electrode active material for a lithium secondary battery according to an exemplary embodiment includes: a metal oxide in the form of a single particle; and a coating layer positioned on the surface of the metal oxide, wherein a concentration of lithium in a 2/5 to 3/5 thickness area based on the total thickness of the coating layer has a lower value than a concentration of lithium in the metal oxide.

In the present exemplary embodiment, an average thickness of the coating layer may be in a range of 100 nm or less, more specifically 18 nm to 75 nm or 25 nm to 65 nm. When the thickness of the coating layer satisfies the range, a positive electrode active material having a significantly decreased high-temperature resistance increase rate while having excellent room temperature resistance and high-temperature life characteristics may be provided.

In the EDS analysis of the positive electrode active material of the present exemplary embodiment, a concentration of nickel in the coating layer may increase in a direction of the metal oxide from the surface. When the concentration of nickel in the coating layer and the metal oxide in the positive electrode active material is shown in the form described above, an excellent capacity of a lithium secondary battery may be secured.

Meanwhile, the positive electrode active material may have a Li/Ni cation mixing ratio of 1.5% or less, more specifically 1.1 to 1.4%. When the Li/Ni cation mixing ratio is too large, a Li layer may easily collapse, which may greatly decrease the life characteristics of a battery. In addition, the Li/Ni cation mixing ratio is too small, an irreversible site of a bulk portion of the positive electrode active material may be increased to reduce lithium ion mobility, which may deteriorate resistance characteristics and output characteristics. Accordingly, when the Li/Ni cation mixing ratio satisfies the range, a positive electrode active material having low resistance and improved life may be implemented, and thus, has an advantageous effect.

In the present specification, the Li/Ni cation mixing ratio refers to an amount of Ni substituted on a Li site.

In the present embodiment, the coating layer may include at least one of Co, Al, W, V, Ti, Nb, Ce, B, and P. Herein, a content of the element included in the coating layer may be in a range of 0.5 mol% to 3.5 mol% based on the entire coating layer. Since the coating layer includes at least one of the elements described above within the range, the surface structure of the positive electrode active material of the present exemplary embodiment may be modified.

In addition, the coating layer includes Co, and the concentration of Co in a 2/5 to 3/5 thickness area based on the total thickness of the coating layer may be higher than the concentration of Co included on the surface of the coating layer and in the metal oxide. The concentrations of Co in the coating layer and the metal oxide in the positive electrode active material are shown in the form described above, a positive electrode active material having excellent battery capacity, efficiency, and high temperature life characteristics may be implemented.

The metal oxide includes nickel, cobalt, and manganese, and the content of nickel may be higher than the sum of the contents of cobalt and manganese in the entire metal oxide.

More specifically, the content of nickel in the metal oxide particles may be 0.8 mol or more based on 1 mol of nickel, cobalt, and manganese. More specifically, the content of nickel may be in a range of 0.8 to 0.99, 0.85 to 0.99, or 0.88 to 0.99 range.

When the content of nickel in the metals of the lithium metal oxide is 0.8 mol or more, a positive electrode active material having high output characteristics may be implemented. Since the positive electrode active material of the present exemplary embodiment having the composition has an increased energy density per volume, the capacity of a battery to which the positive electrode active material is applied may be improved and the positive electrode active material is very appropriate for use as an electric vehicle.

In the positive electrode active material of the present exemplary embodiment, a difference in the concentration of manganese from a 1/2 point of the coating layer thickness to the center of the metal oxide may be 1 mol% or less. That is, the concentration of manganese may be uniformly formed from about a half point of the coating layer thickness to the center of the metal oxide. As such, when the concentration of manganese is uniform, a lithium secondary battery having excellent stability may be provided.

The metal oxide may further include a doping element, and the doping element may include at least one of Al, Zr, Nb, Mo, W, Ti, Ce, Mg, B, P, V, Sr, and B.

The content of the doping element may be in a range of 0.0005 mol to 0.04 mol or 0.001 mol to 0.03 mol, based on a total of 1 mol of nickel, cobalt, manganese, and the doping elements. Herein, the doping element refers to a doping amount of the doping elements included in a finally obtained positive electrode active material.

**In** the positive electrode active material, selection of the doping element is important for securing life and various electrochemical performances. **In** the present exemplary embodiment, the positive electrode active material characteristics may be improved by applying various doping elements as described above.

**In** the present exemplary embodiment, the doping element may include Zr and Al.

Since a Zr ion occupies a Li site, Zr serves as a type of pillar and relieves contraction of a lithium ion path during charging and discharging process to stabilize a layered structure. The phenomenon may decrease so-called cation mixing and increase a lithium diffusion coefficient to increase cycle life.

In addition, an Al ion moves to a tetragonal lattice site to suppress deterioration of the layered structure into a spinel structure in which movement of a lithium ion is less smooth.

The content of Zr may be in a range of 0.001 mol to 0.01 mol, more specifically, 0.0016 to 0.005 mol, based on a total of 1 mol of nickel, cobalt, manganese, and the doping elements. When the Zr doping amount satisfies the range, a high-temperature resistance increase rate may be decreased, and simultaneously excellent life characteristics may be secured.

The content of Al may be in a range of 0.001 mol to 0.04 mol, more specifically 0.004 mol to 0.028 mol, 0.0045 mol to 0.027 mol, or 0.0055 mol to 0.025 mol, based on a total of 1 mol of nickel, cobalt, manganese, and the doping elements. When the Al doping amount satisfies the range, high-temperature life and thermal stability may be further improved.

Next, an average crystalline size of the metal oxide may be 200 nm or more.

When the metal oxide has the average crystalline size, it may be defined as a single particle. In addition, when the average crystalline size satisfies the range, crystallization is performed well, so that residual lithium on the surface of the positive electrode active material may be reduced, and the life characteristics of the lithium secondary battery may be further improved.

In the present specification, the average crystalline size is defined as the size measured by the following method:
1. Sample structure analysis using Rigaku smart lab equipment
2. Applying 45 kV, 200mA (9 kW) to a Cu anode in order to generate X-ray
3. Setting equipment optic to an incident slit of 1/2 deg and a receiving slit of 8.0 mm
4. Performing XRD measurement at scan of 10-80°, step of 0.02°, 10°/min
5. Calculation of crystal size using SmartLab Studio II v4.2.82.0 S/W
6. Using Whole powder pattern fitting (WPPF) in S/W for calculation
7. During WPPF, using a layered structure as the structure and setting profile fitting by a FP method
8. Setting receiving optic to Graphite 002 and Soller slit of 3.8
9. Calculating a crystal size by refining shape to spherical and strain to 0 Fix

An average particle diameter (D50) of the positive electrode active material may be in a range of 2.5 µm or more, more specifically 3.0 µm to 5.0 µm. In the present exemplary embodiment, a positive electrode active material in the form of a single particle having a uniform particle size distribution which has very little fine powder and large powder, without separate expensive shredding equipment or multiple shredding processes, that is, even using a common shredding device, in order to prepare a positive electrode active material in the form of a single particle having the average particle diameter described above, may be prepared. Accordingly, when the average particle diameter of the positive electrode active material of the present exemplary embodiment satisfies the range, a lithium secondary battery having excellent electrochemical properties may be implemented.

Meanwhile, the positive electrode active material of the present exemplary embodiment may further include a positive electrode active material including a metal oxide in the form of a secondary particle formed by agglomeration of primary particles.

That is, the positive electrode active material including the metal oxide in the form of a single particle, and a positive electrode active material including a metal oxide in the form of a secondary particle having an average particle diameter (D50) larger than an average particle diameter (D50) of the positive electrode active material including the metal oxide in the form of a single particle may be included. As such, when the positive electrode active material including the metal oxide in the form of a single particle and the positive electrode active material including the metal oxide in the form of a secondary particle are mixed in a bimodal form as described above, an electrode mixed density may be increased, which is thus preferred.

As such, a mixing ratio between the positive electrode active material including the metal oxide in the form of a single particle and the positive electrode active material including the metal oxide in the form of a secondary particle in the positive electrode active material in a bimodal form may be in a range of 30:70 to 10:90 or 25:75 to 15:85, as a weight ratio (single particle: primary particle). When the positive electrode active materials including the metal oxides in the form of a single particle and in the form of a secondary particle are mixed at the weight ratio, an electrode mixed density may be increased.

Herein, the positive electrode active materials including the metal oxides in the form of a single particle and in the form of a secondary particle may have the same composition as or different compositions from each other. Specifically, both the positive electrode active materials including the metal oxides in the form of a single particle and in the form of a secondary particle may include nickel, cobalt, manganese, and doping elements.

For example, the positive electrode active material including the metal oxide in the form of a secondary particle may include nickel, cobalt, and manganese, and the content of nickel may be higher than the sum of the contents of cobalt and manganese in the entire metal oxide in the form of a secondary particle.

More specifically, the content of nickel in the metal oxide particles in the form of a secondary particle may be 0.8 mol or more based on 1 mol of nickel, cobalt, and manganese. More specifically, the content of nickel may be in a range of 0.8 to 0.99, 0.85 to 0.99, or 0.88 to 0.99.

The metal oxide in the form of a secondary particle may further include a doping element, and the doping element may include at least one of Al, Zr, Nb, Mo, W, Ti, Ce, Mg, B, P, V, Sr, and B.

The detailed description of the contents of the doping elements will be omitted, since they are the same as those of the positive electrode active material including the metal oxide in the form of a single particle described above.

In addition, in the present exemplary embodiment, the average particle diameter (D50) of the positive electrode active material including the metal oxide in the form of a secondary particle may be in a range of 10 µm to 20 µm or 12 µm to 17 µm. When the average particle diameter of the positive electrode active material including the metal oxide in the form of a secondary particle satisfies the range, large and small particles may be positioned in an appropriate distribution in the positive electrode active material in a bimodal form, and thus, the energy density of a lithium secondary battery may be improved.

### Lithium secondary battery

Another exemplary embodiment of the present disclosure provides a positive electrode including the positive electrode active material according to an exemplary embodiment of the present disclosure described above, a negative electrode, and an electrolyte positioned between the positive electrode and the negative electrode.

Specifically, the positive electrode includes a current collector and a positive electrode active material layer formed on the current collector, and the characteristics of the positive electrode active material forming the positive electrode active material layer are as described above. Accordingly, the detailed description of the positive electrode active material will be omitted.

As the current collector, for example, stainless steel, aluminum, nickel, titanium, calcined carbon, or aluminum or stainless steel having a surface treated with carbon, nickel, titanium, silver, and the like may be used.

Meanwhile, the positive electrode active material layer may include a binder and a conductive material.

The binder serves to adhere positive electrode active material particles to each other well and adhere the positive electrode active material to the current collector well.

The conductive material is used for imparting conductivity to an electrode, and in a battery to be configured, any electroconductive material without causing a chemical change may be used.

The positive electrode is manufactured by mixing an active material, a conductive material, and a binder in a solvent to prepare an active material composition, and applying the composition on a current collector. Since the method for manufacturing an electrode as such is well known in the art, the detailed description will be omitted in the present specification. As the solvent, N-methylpyrrolidone and the like may be used, but the present disclosure is not limited thereto.

The negative electrode includes a current collector and a negative electrode active material layer formed on the current collector, and the negative electrode active material layer includes a negative electrode active material.

The negative electrode active material includes a material capable of reversibly intercalating/deintercalating lithium ions, lithium metal, an alloy of lithium metal, a material capable of doping and dedoping lithium, or a transition metal oxide.

The material capable of reversibly intercalating/deintercalating lithium ions is a carbon material and may be any carbon-based negative electrode active material which is commonly used in a lithium ion secondary battery, and a representative example may be crystalline carbon, amorphous carbon, or a combination thereof.

The alloy of lithium metal may be an alloy of lithium and a metal selected from the group consisting of Na, K, Rb, Cs, Fr, Be, Mg, Ca, Sr, Si, Sb, Pb, In, Zn, Ba, Ra, Ge, Al, and Sn.

As the material capable of doping and dedoping lithium may be Si, SiOₓ (0 < x < 2), a Si-Y alloy (Y is an element selected from the group consisting of alkali metals, alkaline earth metals, Group 13 elements, Group 14 elements, transition metals, rare earth elements, combinations thereof, but is not Si.), Sn, SnO₂, Sn-Y (Y is an element selected from the group consisting of alkali metals, alkaline earth metals, Group 13 elements, Group 14 elements, transition metals, rare earth elements, combinations thereof, but is not Sn,) and the like.

The transition metal oxide may be a vanadium oxide, a lithium vanadium oxide, and the like.

The negative electrode active material layer may also include a binder, and optionally, further include a conductive material.

As the binder, polyvinyl alcohol, carboxylmethyl cellulose/styrenebutadiene rubber, hydroxypropylene cellulose, diacetylene cellulose, polyvinyl chloride, polyvinylpyrrolidone, polytetrafluoroethylene, polyvinylidene fluoride, polyethylene, polypropylene, or the like may be used, but the present disclosure is not limited thereto. The binder may be mixed at 1 wt% to 30 wt% with respect to the total amount of a composition for forming the negative electrode active material layer.

The conductive material is not particularly limited as long as it has conductivity without causing a chemical change in a battery, and specifically, may be graphite such as natural graphite and artificial graphite; carbon black such as acetylene black, Ketjen black, channel black, furnace black, lamp black, and thermal black; conductive fiber such as carbon fiber and metal fiber; metal powder such as carbon fluoride, aluminum, and nickel powder; conductive whisky such as zinc oxide and potassium titanate; a conductive metal oxide such as titanium oxide; a conductive material such as a polyphenylene derivative, and the like. The conductive material may be mixed at 0.1 wt% to 30 wt% with respect to the total weight of the composition for a negative electrode active material layer.

As the current collector, a current collector selected from the group consisting of a copper foil, a nickel foil, a stainless steel foil, a titanium foil, a nickel foam, a copper foam, a polymer substrate coated with a conductive metal, and a combination thereof may be used.

The negative electrode is manufactured by mixing an active material, a conductive material, and a binder in a solvent to prepare an active material composition, and applying the composition on a current collector. Since the method for manufacturing an electrode as such is well known in the art, the detailed description will be omitted in the present specification. As the solvent, N-methylpyrrolidone and the like may be used, but the present disclosure is not limited thereto.

In addition, in the lithium secondary battery, as the electrolyte, an organic liquid electrolyte, an inorganic liquid electrolyte, a solid polymer electrolyte, a gel polymer electrolyte, a solid inorganic electrolyte, a molten type inorganic electrolyte, and the like which may be used in the manufacture of a lithium secondary battery may be used, but the present disclosure is not limited thereto.

Specifically, the organic liquid electrolyte may include an organic solvent and a lithium salt.

The organic solvent serves as a medium in which ions involved in an electrochemical reaction of a battery may move.

The lithium salt is a material which is dissolved in an organic solvent, acts as a source of a lithium ion in a battery to allow basic operation of a lithium secondary battery, and serves to promote movement of lithium ions between a positive electrode and a negative electrode.

There may be a separator between the positive electrode and the negative electrode, depending on the type of lithium secondary batteries. As the separator, polyethylene, polypropylene, polyvinylidene fluoride, or a multilayer membrane of two or more layers thereof may be used, and a mixed multilayer membrane such as a polyethylene/polypropylene 2-layer separator, a polyethylene/polypropylene/polyethylene 3-layer separator, and a polypropylene/polyethylene/polypropylene 3-layer separator may be used, of course.

The lithium secondary battery may be classified into a lithium ion battery, a lithium ion polymer battery, and a lithium polymer battery, depending on the type of separators and electrolytes to be used, may be classified into a cylindrical type, a prismatic type, a coin type, a pouch type, and the like, depending on the shape, and may be classified into a bulk type and a thin membrane type, depending on the size. Since the structure and the manufacturing method of the battery are well known in the art, the detailed description thereof will be omitted.

### DETAILED DESCRIPTION OF THE EMBODIMENTS

Hereinafter, exemplary embodiments of the present disclosure will be described in detail. However, these are suggested only as an example and the present disclosure is not limited thereby, and the present disclosure is only defined by the scope of the claims described later.

### Example 1 - Positive electrode active material in the form of single particle, heat treatment at 600°C for 6 hr

### (1) Preparation of precursor

A precursor was prepared by a common co-precipitation method.

Specifically, NiSO₄·6H₂O was used as a nickel raw material, CoSO₄·7H₂O was used as a cobalt raw material, and MnSO₄·H₂O was used as a manganese raw material. These raw materials were dissolved in distilled water to prepare a metal salt aqueous solution.

After preparing a co-precipitation reactor, N₂ was purged in order to prevent oxidation of a metal ion in a co-precipitation reaction, and a temperature of the reactor was maintained at 50°C.

NH₄(OH) as a chelating agent was added to the co-precipitation reactor, and NaOH was used for pH adjustment. Precipitate obtained according to the co-precipitation process was filtered, washed with distilled water, and dried in an oven at 100°C for 24 hours to prepare a positive electrode active material precursor.

The composition of the prepared precursor was (Ni_{0.98}Co_{0.01}Mn_{0.01})(OH)₂ , and the average particle diameter (D50) thereof was about 4 µm.

### (2) Preparation of positive electrode active material

315 g of LiOH·H₂O, 2.94 g of Al(OH)₃, and 1.47 g of ZrO₂ were weighed, respectively, in 684 g of the precursor prepared in (1), and then uniformly mixed, and fired at 830-890°C for 24 hours in a firing furnace in a box form to which oxygen was introduced at 1,000 mL/min, thereby synthesizing a positive electrode material in a metal oxide form. Thereafter, the positive electrode material was crushed using a jet-mill to prepare a positive electrode active material including a metal oxide in the form of a single particle.

About 1.927 g of Co(OH)₂ was mixed per 100 of the metal oxide in the form of a single particle and a heat treatment was performed at 600°C for 6 hours under an oxygen atmosphere to prepare a positive electrode active material having a coating layer formed thereon.

### Examples 2 to 7

Positive electrode active materials having a coating layer formed thereon were prepared in the same manner as in Example 1, except that heat treatment conditions during coating layer formation were adjusted as shown in the following Table 1.

**(Table 1)**

| Classification | Coating layer forming process | |
|---|---|---|
| | Heat treatment temperature (°C) | Heat treatment time (hr) |
| Example 1 | 600 | 6 |
| Example 2 | 620 | 6 |
| Example 3 | 640 | 6 |
| Example 4 | 660 | 6 |
| Example 5 | 680 | 6 |
| Example 6 | 700 | 6 |
| Example 7 | 720 | 6 |

### Example 8(1) Preparation of precursor

A precursor was prepared in the same manner as in Example 1, except that the composition was (Ni_{0.92}Co_{0.04}Mn_{0.04})(OH)₂, and the average particle diameter (D50) was about 14.5 µm.

### (2) Preparation of positive electrode active material having large particle diameter

325 g of LiOH·H₂O, 11.4 g of Al(OH)₃, and 3.2 g of ZrO₂ were weighed, respectively in 684 g of the precursor prepared in (1), uniformly mixed, and fired at 830-890°C for 24 hours in a firing furnace in a box form to which oxygen was introduced at 1,000 mL/min, thereby synthesizing a positive electrode material in a metal oxide form.

Thereafter, the positive electrode material was crushed using an air classifying mill (ACM), washed for removing residual lithium on the surface, and dried for 12 hours.

Next, a mixture of about 0.35 g of boric acid (H₃BO₃) per 100 of the dried positive material was heat treated at 250°C-300°C for 5 hours under an air atmosphere.

### (3) Preparation of bimodal positive electrode active material

A bimodal positive electrode active material was prepared by mixing the positive electrode active material prepared in (2) and the positive electrode active material prepared according to Example 4 at a weight ratio of 8:2.

### Comparative Example 1

### (1) Preparation of precursor

A precursor was prepared in the same manner as in Example 1.

### (2) Preparation of positive electrode active material

315 g of LiOH·H₂O, 2.94 g of Al(OH)₃, and 1.47g of ZrO₂ were weighed, respectively, in 684 g of the precursor prepared in (1), uniformly mixed, and fired at 830-890°C for 24 hours in a firing furnace in a box form to which oxygen was introduced at 1,000 mL/min, thereby synthesizing a positive electrode material in a metal oxide form. Thereafter, the positive electrode material was crushed using a jet-mill to prepare a positive electrode active material including a metal oxide in the form of a single particle.

### Comparative Example 2

A positive electrode active material according to Comparative Example 2 was prepared by further heat treating the positive electrode active material prepared according to Comparative Example 1 at 660°C for 6 hours.

### Comparative Example 3 - Forming Co coating layer in a wet manner

A positive electrode active material was prepared in the same manner as in Comparative Example 1.

Next, 0.03 g of LiNO₃ and 11.74 g of Co(NO₃)₂·6H₂O were dissolved in 100 g of H₂O heated to 60°C, a slurry obtained by adding 100 g of the positive electrode material of Comparative Example 1 was stirred for 30 minutes, and the slurry was spray dried to obtain a powder body. The powder body was placed in an alumina crucible, heated to about 450°C at about 5°C per minute, and maintained at about 450°C for about 1 hours, and the temperature was heated to about 700°C at about 2°C per minute and then maintained for about 2 hours. Subsequently, the sample was cooled to room temperature to prepare the positive electrode active material according to Comparative Example 2.

### Experimental Example 1: Evaluation of electrochemical performance

### (1) Manufacture of coin-type half battery

In order to evaluate the physical properties and electrochemistry of the positive electrode active materials prepared in Examples 1 to 8 and Comparative Examples 1 and 2, a coin-type half battery was manufactured as follows.

Specifically, the positive electrode active material, a polyvinylidene fluoride binder (product name: KF1120), and a carbon black conductive material were mixed at a weight ratio of 96.5:1.5:2, and the mixture was added to a N-methyl-2-pyrrolidone solvent to the solid content of about 30 wt%, thereby preparing a positive electrode active material slurry.

An aluminum foil (thicikness: 15 µm) as a positive electrode current collector was coated with the slurry using a doctor blade, dried, and rolled to manufacture a positive electrode. The loading amount of the positive electrode was about 15 mg/cm², an electrode thickness was about 65 µm, and a rolling density was about 3.4 g/cm³ or more.

A 2032 coin-type half battery was manufactured by a common method, using the positive electrode, a lithium metal negative electrode (thickness: 300 µm, MTI), an electrolytic solution, and a polypropylene separator. As the electrolyte solution, a mixed solution obtained by dissolving 1M LiPF₆ in a mixed solvent of ethylene carbonate, dimethyl carbonate, and ethyl methyl carbonate (EMC) (mixing ratio of EC:DMC:EMC = 3:4:3 vol%) was used. After manufacturing the half battery, it was aged at room temperature for 10 hours.

### (2) Measurement of residual lithium and particle size

Residual lithium was measured using T50 model available from METTLER TOLEDO, and a particle size was measured using S3500 model available from Microtrac.

### (3) Capacity evaluation

The coin-type half battery manufactured according to experimental preparation was aged at room temperature (25°C) for 10 hours, and then was subjected to a charge/discharge test.

For capacity evaluation, 200 mAh/g was used as a reference capacity, and CC/CV 2.5-4.25V and 1/20 C cut-off were applied as charge and discharge conditions. Initial capacity was measured at charging at 0.2 C/ discharging at 0.2 C.

### (4) Measurement of life characteristics

Life characteristics were measured 50 times at a high temperature (45°C) in the conditions of charging at 0.5 C/ discharging at 1.0 C.

### (5) Measurement of resistance characteristics

Initial room temperature resistance (DC internal resistance: DC-IR (direct current internal resistance)) was obtained by performing charge at 0.2 C and discharge at 0.2 of a battery once under the conditions of a constant current-constant voltage of 2.5V to 4.25V and 1/20C cut-off at 25°C, applying a discharge current at 100% charge at 4.25 V, measuring a voltage value after 60 seconds, and then performing calculation.

A resistance increase rate was obtained by measuring resistance at 45°C in the same manner as in the initial resistance measurement method, after 30 times of cycle life as compared with the initially measured resistance (initial resistance at room temperature), and then converting the increase rate as a percentage (%)..

### Experimental Example 2: X-ray diffraction evaluation

- Sample structure analysis using Rigaku smart lab equipment
- Applying 45 kV, 200 mA (9kW) to a Cu anode for generating X-ray
- Setting equipment optic to an incident slit of 1/2 deg and a receiving slit of 8.0 mm
- XRD measurement at scan of 10-80°, step of 0.02°, 10°/min

### Experimental Example 3: Method for measuring cation mixing ratio

1. Sample structure analysis using Rigaku smart lab equipment
2. Applying 45 kV, 200 mA (9kW) to a Cu anode for generating X-ray
3. Setting equipment optic to an incident slit of 1/2 deg and a receiving slit of 8.0 mm
4. XRD measurement at scan of 10-80°, step of 0.02°, 10°/min
5. Calculating crystal size using SmartLab Studio II v4.2.82.0 S/W
6. Using whole powder pattern fitting (WPPF) in S/W for calculation
7. Using layered structure as the structure and setting a profile fitting by FP method in proceeding with WPPF
8. Setting receiving optic to graphite 002 and soller slit to 3.8
9. Calculating a crystal size by refining a shape to spherical and a strain to 0 Fix
10. Using occupancy of Ni1 in a crystal structure tap as a cation mixing value

**(Table 2)**

| | Residual Lithium[wt%] | | | Partic le size D50 [um] | Cryst alline size [nm] | Cati on mixi ng (%) | Charg e capacit y at 0.2 C [mAh/g ] | Discha rge capacit y at 0.2 C [mAh/g ] | Effic ienc y [%] | Roo m temp eratur e resist ance [Ω] | High-temp eratur e life [%] | High-temper ature resistan ce increas e rate [%] |
|---|---|---|---|---|---|---|---|---|---|---|---|---|
| | LiO H | Li₂C O₃ | Total | | | | | | | | | |
| Comp arative Examp le 1 | 0.81 | 0.32 | 1.13 | 3.4 | 253 | 1.4 | 249.7 | 212.4 | 85.0 | 46.5 | 90.5 | 45.2 |
| Comp arative Examp le 2 | 0.18 | 0.60 | 0.78 | 3.7 | 254 | 1.3 | 248.5 | 214.0 | 86.1 | 45.8 | 91.0 | 40.1 |
| Comp arative Examp le 3 | 0.10 | 0.14 | 0.24 | 3.8 | 239 | 1.7 | 246.3 | 214.6 | 87.1 | 28 | 91.8 | 72.8 |
| Examp le 1 | 0.13 | 0.50 | 0.63 | 3.8 | 264 | 1.1 | 248.6 | 214.8 | 86.4 | 45.3 | 91.7 | 38.4 |
| Examp le 2 | 0.14 | 0.49 | 0.63 | 3.8 | 264 | 1.5 | 249.1 | 216.9 | 87.1 | 40.5 | 92.4 | 37.6 |
| Examp le 3 | 0.14 | 0.43 | 0.57 | 3.8 | 257 | 1.4 | 247.4 | 216.6 | 87.6 | 38.2 | 92.4 | 35.6 |
| Examp le 4 | 0.14 | 0.39 | 0.53 | 3.8 | 253 | 1.2 | 248.6 | 217.2 | 87.4 | 36.6 | 92.6 | 34.1 |
| Examp le 5 | 0.12 | 0.42 | 0.53 | 3.8 | 253 | 1.4 | 247.8 | 216.3 | 87.3 | 36.6 | 92.2 | 34.0 |
| Examp le 6 | 0.14 | 0.38 | 0.53 | 3.8 | 248 | 1.3 | 247.8 | 215.3 | 86.9 | 34.1 | 91.1 | 37.8 |
| Examp le 7 | 0.12 | 0.44 | 0.56 | 3.9 | 247 | 1.4 | 248.7 | 215.9 | 86.8 | 35.1 | 90.4 | 38.8 |
| Examp le 8 | 0.14 | 0.25 | 0.39 | - | - | 0.3 | 245.5 | 219.2 | 89.3 | 32.8 | 94.1 | 37.7 |

Referring to Table 2, it was confirmed that Examples 1 to 8 to which the positive electrode active material including the metal oxide in the form of a single particle on which a Co coating layer was formed was applied had better electrochemical performance such as increased discharge capacity and improved life performance than Comparative Examples 1 and 2 having no Co coating layer formed thereon. In particular, it was found that the positive electrode active material according to Example 4 manufactured under the conditions of a heat treatment temperature of a coating layer formation process of 660°C had the best characteristics of a discharge capacity at 0.2 C, lifespan, and a high-temperature resistance increase rate.

### Experimental Example 4: Positive electrode active material structure analysis

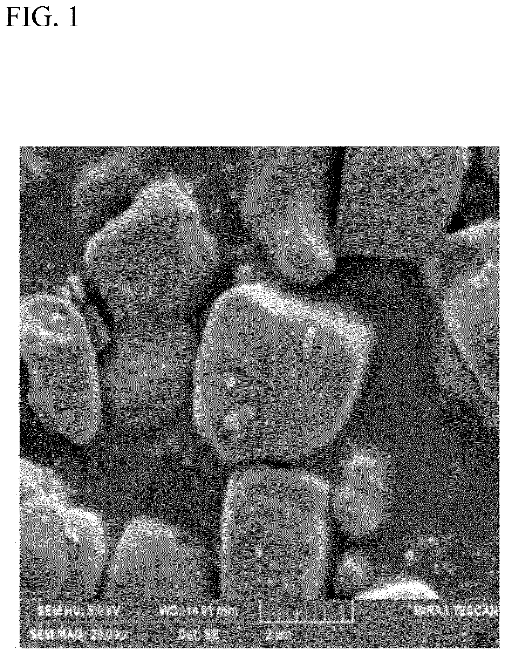

The results of measuring SEM images of the positive electrode active materials prepared according to Examples 2 and 4 and Comparative Example 3 are shown in FIGS. 1 to 3.

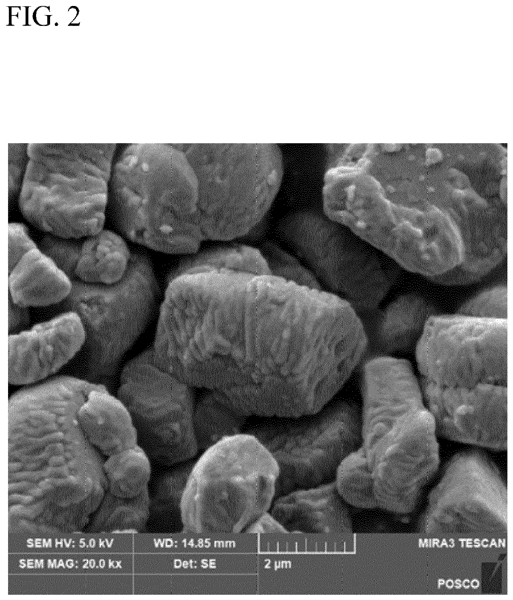

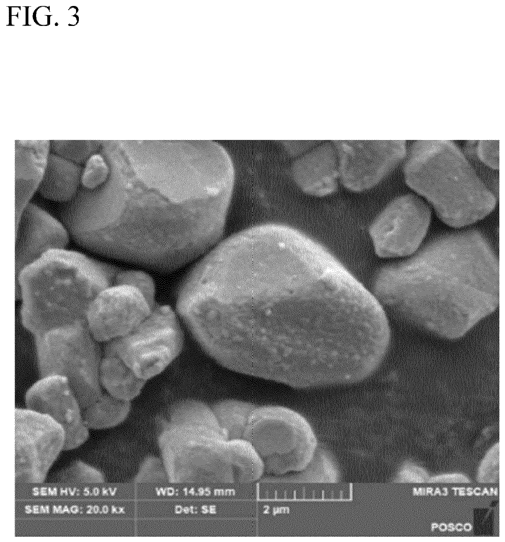

Specifically, FIG. 1 is an SEM image measured at 20,000X magnification for a positive electrode active material prepared according to Example 2, FIG. 2 is an SEM image measured at 20,000X magnification for a positive electrode active material prepared according to Example 4, and FIG. 3 is an SEM image measured at 20,000X magnification for a positive electrode active material prepared according to Comparative Example 3.

Referring to FIGS. 1 to 3, in FIGS. 1 and 2 showing the positive electrode active material of Examples 1 to 4 in which the coating layer was formed by a dry method, winkles were observed on the surface, but in Comparative Example 3 showing the positive electrode active material of Comparative Example 3 in which the coating layer was formed by a wet method, a smooth surface shape was confirmed.

By forming the coating layer by a wet method as such, the electrochemical properties of the positive electrode active material having wrinkles on the surface were excellent.

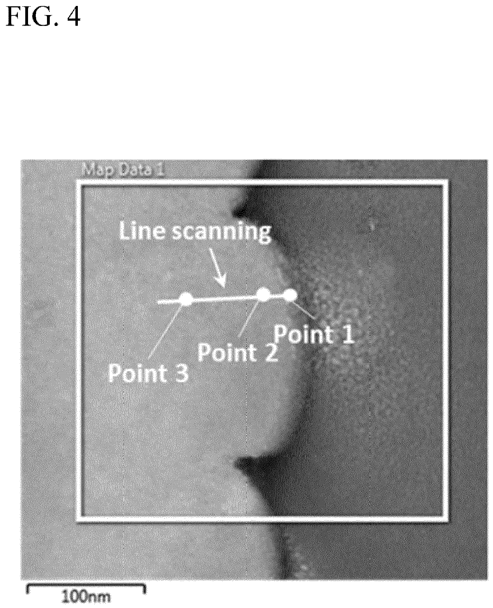

Next, FIG. 4 is a cross-sectional TEM image of the positive electrode active material prepared according to Example 4 after a milling treatment with Focused Ion Beam (FIB, SEIKO 3050SE).

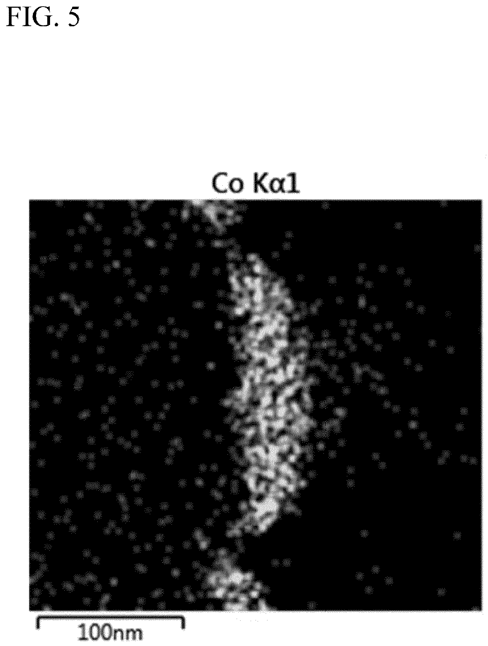

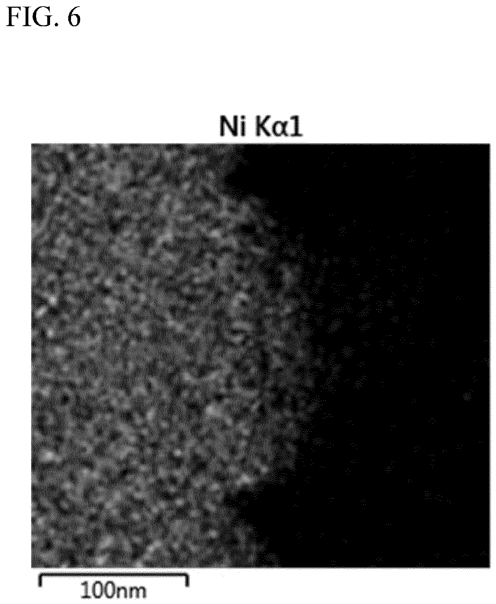

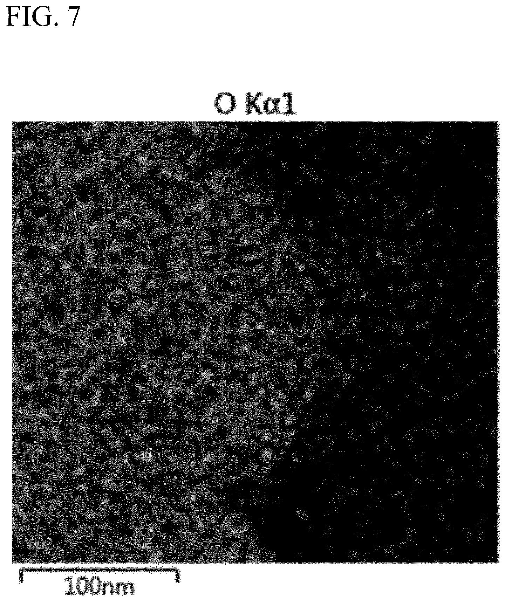

FIGS. 5 to 7 show results after element mapping of the positive electrode active material prepared according to Example 4 using TEM EDS (Energy dispersed spectroscopy, Oxford X_max 100TLE) analysis equipment, after a milling treatment with Focused Ion Beam (FIB, SEIKO 3050SE), respectively.

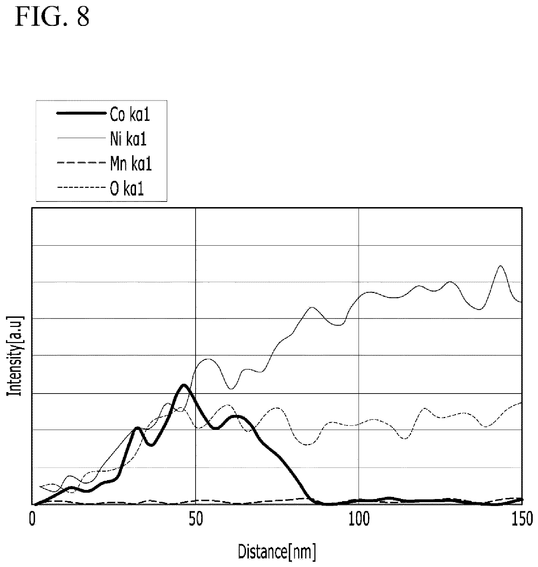

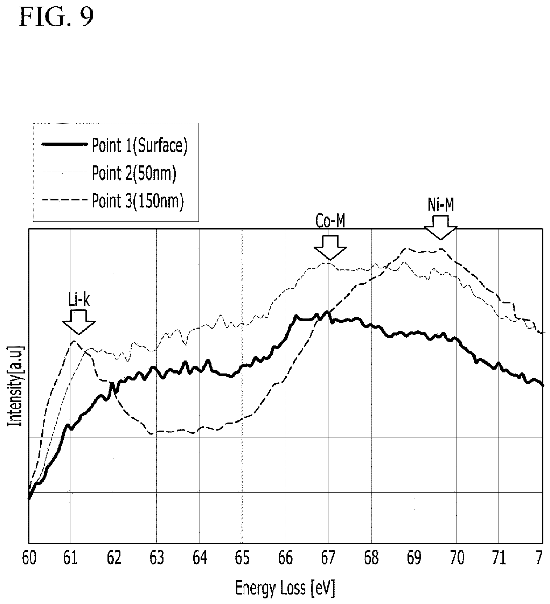

In addition, FIG. 8 is a TEM-EDS line scanning graph of FIG. 4 and FIG. 9 is an TEM-EELS graph at point 1, point 2, and point 3 of FIG. 4.

Referring to FIGS. 5 to 7, it was confirmed that there were cobalt, nickel, and oxygen on the coating layer of the positive electrode active material of Example 4.

In addition, referring to FIG. 8, in Example 4, it was found that the thickness of the coating layer of the positive electrode active material was about 80 nm and the content of cobalt was the highest at a 50 nm position from the surface. That is, it was confirmed that the concentration of Co in a 2/5 to 3/5 thickness area based on the total thickness of the coating layer of Example 4 was higher than the concentration of Co included on the surface of the coating layer and in the metal oxide.

Referring to FIG. 9, in the positive electrode active material of Example 4, it was found that the concentration of lithium was lower than the concentration of lithium of the metal oxide at a 1/2 point of the total coating layer thickness or at about a point where the content of Co was the highest. Specifically, it was confirmed that the content of lithium increased in the direction of the metal oxide (base material) from the surface of the coating layer. In addition, it was found that the concentration of nickel in the positive electrode active material increased in the direction of the metal oxide from the surface.

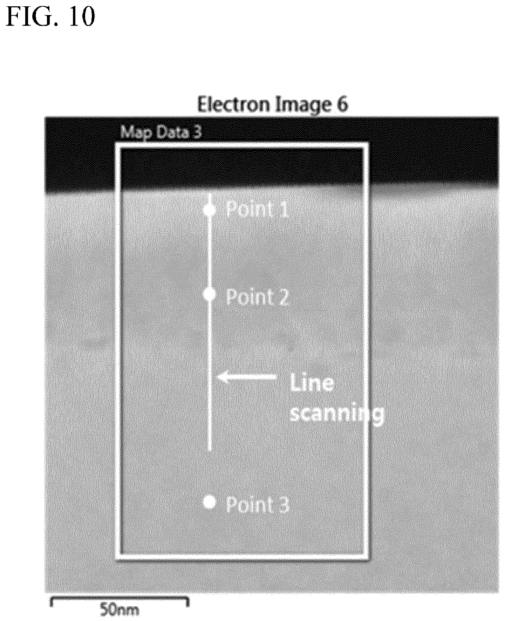

FIG. 10 is a cross-sectional TEM image of positive electrode active material prepared according to Comparative Example 2 after a milling treatment with Focused Ion Beam (FIB, SEIKO 3050SE).

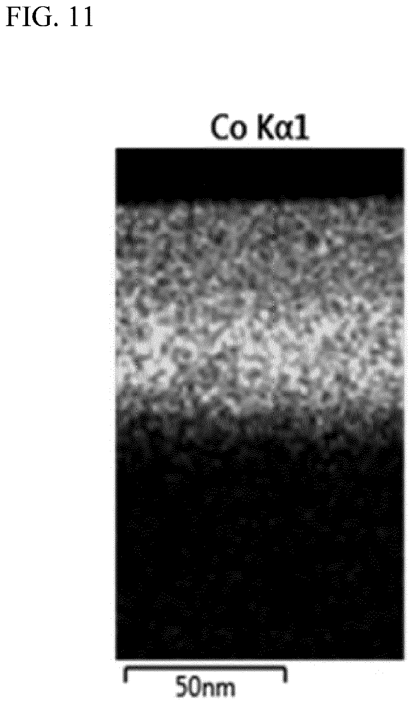

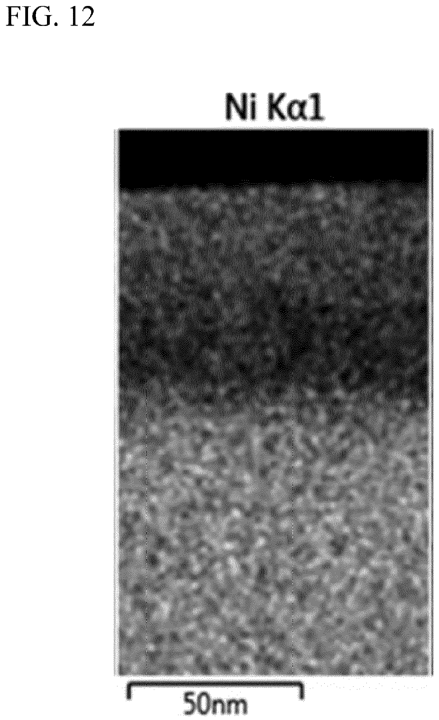

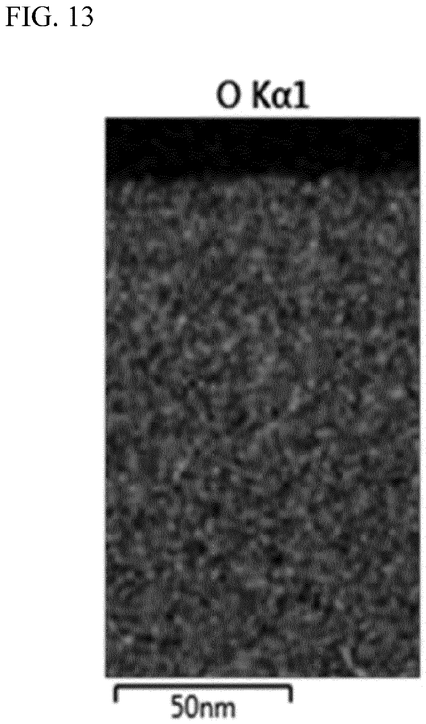

FIGS. 11 to 13 show results after element mapping of the positive electrode active material prepared according to Comparative Example 2 using Energy dispersed spectroscopy (EDS, Oxford X_max 100TLE) analysis equipment, respectively.

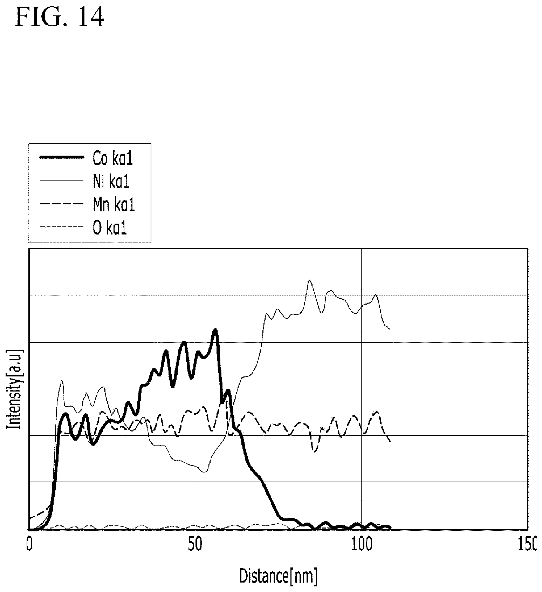

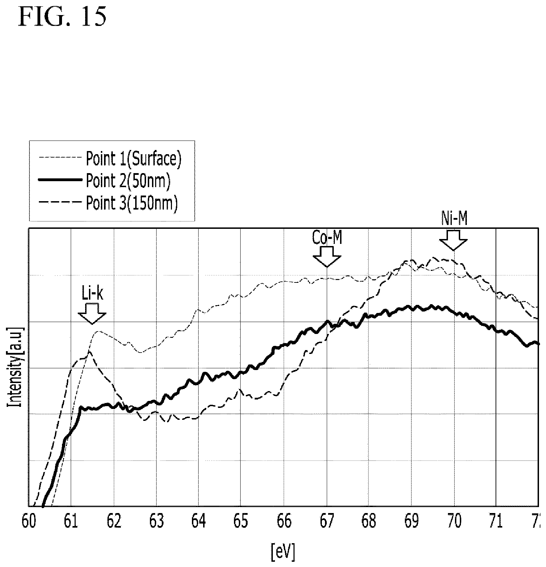

In addition, FIG. 14 is a TEM-EDS Line scanning graph of FIG. 10, and FIG. 15 is an EELS graph at point 1, point 2, and point 3 of FIG. 10.

Referring to FIG. 14, in Comparative Example 3 in which the coating layer was formed by a wet method, the thickness of the coating layer was 80 nm, and the concentration of cobalt was shown to be higher in an area outside the 2/5 to 3/5 thickness area from the surface based on the total thickness of the coating layer.

In addition, referring to FIG. 15, it was found that the concentration of lithium in the coating layer was higher than the concentration of lithium in the metal oxide.

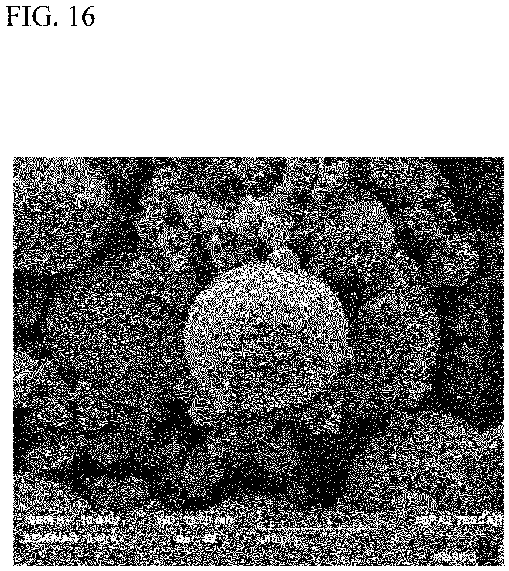

FIG. 16 is an SEM image measured at 5,000X magnification for a positive electrode active material prepared according to Example 8. That is, it is related to the positive electrode active material prepared in a bimodal form.

Referring to FIG. 16, it was confirmed that polycrystalline particles of a large particle diameter and single particles of a small particle diameter were uniformly mixed.

The positive electrode active material according to an exemplary embodiment is in the form of a single particle, has a coating layer on the surface, and has a surface structure modified so that the concentration of lithium in a certain thickness area based on a half point of the total thickness of the coating layer is controlled, thereby implementing a discharge capacity, a resistance at room temperature, a high-temperature lifespan, and high-temperature resistance characteristics which are all improved, and thus, has a very advantageous effect.

The present disclosure is not limited by the above exemplary embodiments and may be manufactured in various forms different from each other, and it may be understood that a person with ordinary skill in the art to which the present disclosure pertains may carry out the present disclosure in another specific form without modifying the technical idea or essential feature of the present disclosure. Therefore, it should be understood that the exemplary embodiments described above are illustrative and are not restrictive in all aspects.

## Claims

1. A positive electrode active material for a lithium secondary battery comprising:
a metal oxide in the form of a single particle; and
a coating layer positioned on the surface of the metal oxide,
wherein a concentration of lithium in a 2/5 to 3/5 thickness area based on the total thickness of the coating layer has a lower value than a concentration of lithium in the metal oxide.

2. The positive electrode active material for a lithium secondary battery of claim 1, wherein:
an average thickness of the coating layer is 100 nm or less.

3. The positive electrode active material for a lithium secondary battery of claim 1, wherein:
in EDS analysis of the positive electrode active material,
a concentration of nickel in the positive electrode active material increases in a direction of the metal oxide from the surface of the coating layer.

4. The positive electrode active material for a lithium secondary battery of claim 1, wherein:
the positive electrode active material has a Li/Ni cation mixing ratio of 1.5% or less.

5. The positive electrode active material for a lithium secondary battery of claim 1, wherein:
the coating layer includes at least one of Co, Al, W, V, Ti, Nb, Ce, B, and P.

6. The positive electrode active material for a lithium secondary battery of claim 5, wherein:
the coating layer includes Co, and
the concentration of Co in a 2/5 to 3/5 thickness area based on the total thickness of the coating layer is higher than the concentration of Co included on the surface of the coating layer and in the metal oxide.

7. The positive electrode active material for a lithium secondary battery of claim 1, wherein:
the metal oxide includes nickel, cobalt, and manganese, and
a content of nickel is higher than the sum of contents of cobalt and manganese in the entire metal oxide.

8. The positive electrode active material for a lithium secondary battery of claim 7, wherein:
a difference in the concentration of manganese from a 1/2 point of the coating layer thickness to the center of the metal oxide is 1 mol% or less.

9. The positive electrode active material for a lithium secondary battery of claim 7, wherein:
the metal oxide further includes a doping element, and
the doping element includes at least one of Al, Zr, Nb, Mo, W, Ti, Ce, Mg, B, P, V, Sr, and B.

10. The positive electrode active material for a lithium secondary battery of claim 1, wherein:
a crystalline size of the metal oxide is 200 nm or more.

11. The positive electrode active material for a lithium secondary battery of claim 10, wherein:
the positive electrode active material further includes a positive electrode active material further including a metal oxide in the form of a secondary particle formed by agglomeration of primary particles.

12. The positive electrode active material for a lithium secondary battery of claim 11, wherein:
an average particle diameter (D50) of the positive electrode active material including the metal oxide in the form of a secondary particle is larger than an average particle diameter (D50) of the positive electrode active material including the metal oxide in the form of a single particle.

13. The positive electrode active material for a lithium secondary battery of claim 11, wherein:
the metal oxide in the form of a secondary particle includes nickel, cobalt, and manganese,
a content of the nickel is higher than the sum of contents of the cobalt and the manganese in the entire metal oxide in the form of a secondary particle.

14. The positive electrode active material for a lithium secondary battery of claim 13, wherein:
the metal oxide in the form of a secondary particle further includes a doping element, and
the doping element includes at least one of Al, Zr, Nb, Mo, W, Ti, Ce, Mg, B, P, V, Sr, and B.

15. The positive electrode active material for a lithium secondary battery of claim 11, wherein:
compositions of the positive electrode active material including the metal oxides in the form of a single particle and in the form of a secondary particle are identical to or different from each other.

16. A lithium secondary battery comprising:
a positive electrode including the positive electrode active material of any one of claims 1 to 15;
a negative electrode; and
an electrolyte.
